# EUROPÄISCHE PATENTSCHRIFT

(11) **EP 0 852 983 B1**
(45) Veröffentlichungstag und Bekanntmachung des Hinweises auf die Patenterteilung: **04.09.2002**
(21) Anmeldenummer: 97121292.3
(22) Anmeldetag: 04.12.1997
(51) Int. Cl.: B23K 1/20

(54) **Einrichtung zum Formen von flüssigen Lotportionen beim Weichlöten von Halbleiterchips**
Brazing parts forming device used for soft soldering of semiconductor chips
Dispositif pour former des portions fluides de brasures pour le brasage tendre de semi-conducteurs

(30) Priorität: 08.01.1997 CH 2797
(43) Veröffentlichungstag der Anmeldung: 15.07.1998
(73) Patentinhaber: ESEC Trading SA, 6330 Cham (CH)
(72) Erfinder: Lüchinger, Christoph B., Dr., 6330 Cham (CH); Suter, Guido, 6312 Steinhausen (CH); Lothenbach, Michael, 6340 Baar (CH)
(74) Vertreter: Falk, Urs, Dr.

(56) Entgegenhaltungen:
- US-A- 3 539 160
- US-A- 4 634 043
- CHRISTENSEN ET AL.: "Flux removal tool" IBM TECHNICAL DISCLOSURE BULLETIN, Bd. 19, Nr. 9, 9.Februar 1977, Seiten 3395-3396, XP002035203

## Beschreibung

Bei der Montage von Halbleiterchips auf einem Substrat durch Weichlöten ist jeweils vor dem Aufsetzen eines Chips die benötigte Weichlotportion auf dem Substrat zu plazieren. Eine dabei häufig angewandte Methode besteht darin, mit dem Ende eines Lötmetall-Drahtes die betreffende Stelle des über den Schmelzpunkt des Lotes erhitzten Substrats - typischerweise ein Systemträger (lead frame) aus einer Kupferlegierung - zu berühren, um ein Stück des Drahtes abzuschmelzen. Bekannt ist ferner, diskrete, feste Lotpartikel auf das beheizte Substrat aufzulegen. Die in beiden Fällen entstehenden, flüssigen Lotportionen sind mehr oder weniger kalottenförmig, wobei Form und Lage der Lottropfen u.a. sehr stark von den örtlichen Benetzungseigenschaften der Substratoberfläche abhängen.

Für eine einwandfreie Lötverbindung des nachher auf die Lotportion aufgelegten Chips wird indessen eine flache, unter der gesamten Chipfläche ausgebreitete Lotschicht möglichst gleichmässiger Dicke gefordert. Bei der erwähnten Tropfenform und seitlichen Lageabweichungen der einzelnen Tropfen ist es jedoch schwierig, alle diese Anforderungen zuverlässig und mit ausreichender Genauigkeit zu erfüllen. Zu beachten sind auch die bei der Chipmontage angewendeten hohen Taktraten, was bedeutet, dass die Chips allgemein mit hoher Geschwindigkeit auf das Substrat bzw. das flüssige Lot zubewegt werden. Es sind deshalb Einrichtungen verwendet worden, um eine Formänderung vom Lottropfen zur dünnen, ausgebreiteten Lotschicht vorbereitend vor dem Aufsetzen des Chips herbeizuführen. Eine bekannte solche Einrichtung besteht im wesentlichen aus einem in Bezug auf das Substrat hebund senkbaren Schaft und einem mit diesem verbundenen Stempel mit einer unteren, dem Substrat zugekehrten Stempelfläche. Damit kann aber die beabsichtigte Wirkung in verschiedener Hinsicht nur unvollkommen erreicht werden: Zunächst ist nachteilig, dass der Stempel auf eine genau vorgegebene, geringe Höhe über dem Substrat abgesenkt werden muss, was eine entsprechend genaue Mechanik erfordert und eine angepasste, niedrige Endgeschwindigkeit bedingt. Dicken- und Lageabweichungen des Substrats wie auch u.U. wechselnde Schieflagen desselben bleiben dabei unberücksichtigt und wirken sich direkt auf die Dicke und sehr stark auf die Breitenausdehnung der Lotverteilung aus. Bereits geringe Winkelabweichungen zwischen der Stempelfläche und der Substrat-Oberfläche bewirken auch erhebliche seitliche Verschiebungen der Lotflecke. Überdies entsteht beim "Plattdrücken" der Lottropfen mittels einer solchen Einrichtung jeweils ein mehr oder weniger runder Lotfleck, der dem rechteckigen oder quadratischen Chipformat schlecht angepasst ist.

Mit der vorliegenden Erfindung wird angestrebt, die vorgenannten Nachteile zu überwinden und eine praxisgerechte Einrichtung zum vorbereitenden Formen flüssiger Lotportionen zu schaffen. Insbesondere sollen die geforderte Form und Lage der Lotportionen auch bei sich ändernden Verfahrensbedingungen und Materialeigenschaften mit möglichst geringen Variationen eingehalten werden.

Die Erfindung geht aus von einer Einrichtung der weiter oben erwähnten Art. Zur Erfüllung der vorstehenden Aufgabe ist sie dadurch gekennzeichnet, dass der Stempel am Schaft vertikal federnd geführt und bezüglich dessen Bewegungsachse allseitig schwenkbar sowie reibschlüssig gelagert ist, und dass am Stempel Distanzhaltemittel vorhanden sind, die über die Stempelfläche vorstehen und zum Aufsetzen auf dem Substrat bestimmt sind.

Mit einer solchen erfindungsgemässen Bauweise der Einrichtung muss nicht mehr beim Absenken des Schaftes eine genau bestimmte Höhe der Stempelfläche angefahren werden, sondern es muss nur der Hub des Schaftes so eingestellt werden, dass die Distanzhaltemittel sicher auf dem Substrat zur Auflage kommen. Dank dieser Distanzhaltung und der Einfederung des Stempels in Bezug auf den Schaft sowie der allseitigen Schwenkbarkeit stellt sich immer ein genauer Abstand der Stempelfläche parallel zur Substrat-Oberfläche ein, unabhängig von Dicken- und Lageabweichungen des Substrates usw.. Infolge reibschlüssiger Lagerung des Stempels bleibt seine jeweilige Ausrichtung beim Abheben vom Substrat erhalten, es erfolgt aber bei jedem Aufsetzen eine selbsttätige Lageanpassung. Wegen der Selbstjustierung des Stempels wird auch der Aufwand beim Einrichten der Maschine für ein neues Produkt erheblich vermindert, und das Einrichten ist weniger abhängig von der Geschicklichkeit des Personals.

Als weiterer Vorteil ergibt sich, dass wegen der Parallelität der Stempelfläche zum Substrat seitliche Lagefehler beim Aufsetzen des Lottropfens geringere Auswirkung auf die Variation des Schwerpunktes der entstehenden flachen Lotverteilungen haben. Insbesondere können aber, gemäss einer bevorzugten Ausführungsform der Erfindung, die Distanzhaltemittel als umlaufender, von der Stempelfläche abstehender Rand ausgebildet sein. Ein solcher Rand begrenzt und zentriert die Lotmasse während ihrer Ausbreitung aktiv. Entsprechend dem Grundriss dieses Randes wird ein (niedriger) Hohlraum für das Lot definiert, dessen Flächenausdehnung auf das Format der aufzulötenden Chips abgestimmt ist.

Insgesamt ermöglicht die Erfindung das vorbereitende Verformen von Lotportionen mit kurzen Taktzeiten, abgestimmt auf die Erfordernisse der anschliessenden Chipmontage und zuverlässig auch unter wechselnden Verfahrensbedingungen.

Verschiedene konkrete Ausführungsbeispiele der erfindungsgemässen Einrichtung und deren Wirkungsweise werden nachstehend im Zusammenhang mit der Zeichnung erläutert.
- Fig. 1: ist eine vereinfachte Gesamtdarstellung einer Einrichtung als Vertikalschnitt;
- Fig. 2: zeigt den unteren Bereich der Einrichtung nach Fig. 1 im Zusammenwirken mit dem Substrat und dem Lot, in mehreren Phasen a bis e eines Arbeitszyklus;
- Fig. 3 bis 5: zeigen in analoger Darstellung ein Beispiel einer schwenkbaren Lagerung des Stempels, wobei Fig. 5 gegenüber den Fig. 3 und 4 um 90° um die Vertikalachse gedreht ist;
- Fig. 6: zeigt den Stempel in der Lage nach Fig. 5 in Seitenansicht;
- Fig. 7 und 8: zeigen ein weiteres Ausführungsbeispiel, hier für Schnappmontage des Stempels an einem Kugelkopf, und zwar bei Fig. 7 mit gelöster und bei Fig. 8 mit hergestellter Verbindung;
- Fig. 9, 10 und 11: sind Ansichten der Unterseite eines Stempels mit verschiedenen Beispielen von Distanzhaltemitteln.

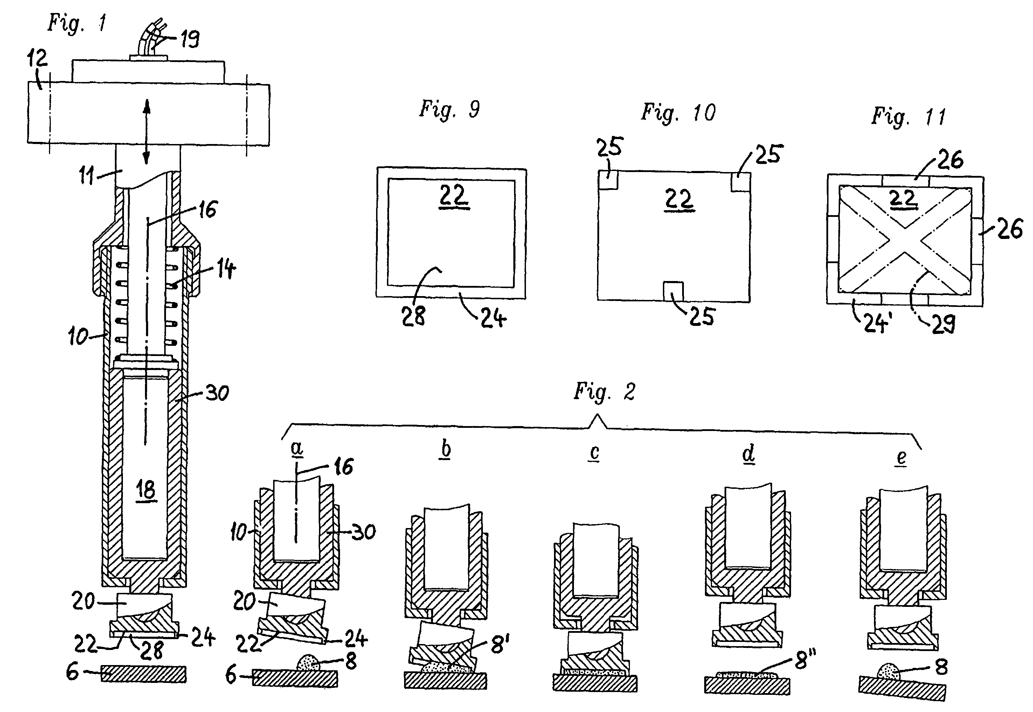

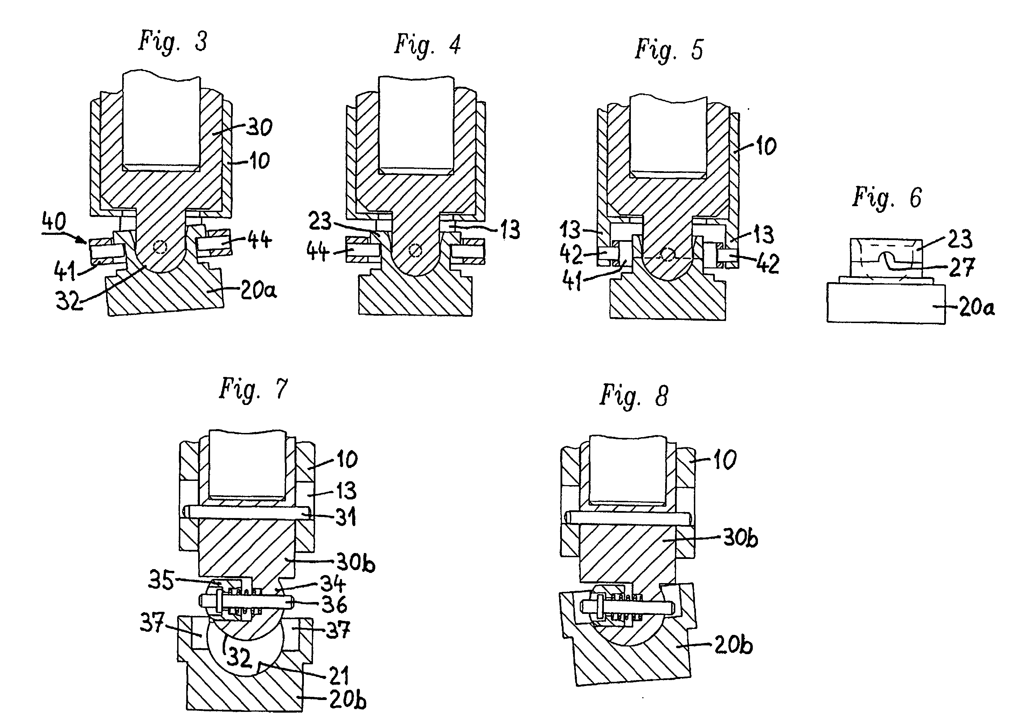

Es sei hier vorausgeschickt, dass in der Zeichnung sowohl die Höhe der Distanzhaltemittel (Fig. 1, 2) als auch die Seitenneigung des Stempels (Fig. 2a, 2b, 3, 8) oder des Substrats (Fig. 2e) zur Verdeutlichung stark übertrieben dargestellt sind; in der Praxis beträgt die Distanz zwischen Stempelfläche und Substrat (entsprechend der geforderten Dicke der Lotverteilung) nur wenige Hundertstel mm, und es handelt sich um Winkelabweichungen von wenigen Grad oder gar nur Bruchteilen eines Grades. Aus diesem Grund sind in den geschnittenen Figuren 3, 4, 5, 7 und 8 die Distanzhaltemittel nicht dargestellt bzw. nicht erkennbar.

Bei der Einrichtung nach Fig. 1 ist ein vertikaler Schaft, bestehend aus den Teilen 10 und 11, erkennbar. Der untere Teil 10 ist als Hülse ausgebildet, die oben mit einem Tragrohr 11 verschraubt ist. Ein mit dem Tragrohr 11 verbundener Flansch 12 dient zur Befestigung der Einrichtung an einem nicht näher dargestellten Antriebsmechanismus eines Chip-Montageautomaten. Wie mit vertikalen Pfeilen angedeutet, ist der Schaft - und mit ihm die ganze Einrichtung - damit heb- und senkbar. Unter der Einrichtung befindet sich ein Substrat 6, typischerweise ein Leadframe-Streifen, der in Richtung senkrecht zur Zeichnungsebene schrittweise weiterbewegt wird. Auf das beheizte Substrat 6 werden an einer Stelle vor der Einrichtung (bezogen auf die Bewegungsrichtung des Substrats) Weichlot-Portionen 8 (Fig. 2a) aufgebracht. Die flüssigen Lotportionen werden mittels der Einrichtung verformt, und an einer Stelle hinter der Einrichtung wird hierauf ein Chip auf die vorbereitete Lotverteilung aufgelegt und dadurch mit dem Substrat verlötet. Diese Funktionsschritte sind in der Halbleiter-Montagetechnik generell bekannt und deshalb hier nicht näher dargestellt.

Zur Einrichtung nach Fig. 1 gehört ein Stempel 20 mit einer unteren, dem Substrat 6 zugekehrten Stempelfläche 22. Der Stempel 20 ist an einem Tragteil 30 gehalten, und zwar bezüglich der vertikalen Bewegungsachse 16 des Schaftes allseitig schwenkbar sowie reibschlüssig und zweckmässigerweise austauschbar, wie weiter unten anhand von Beispielen beschrieben. Das Tragteil 30 ist in der Hülse 10 des Schaftes vertikal gleitend geführt; eine Relativverschiebung nach oben erfolgt entgegen der Kraft einer Druckfeder 14, die zwischen dem Tragteil 30 und dem Tragrohr 11 des Schaftes verspannt ist.

Der Stempel 20 und das Tragteil 30 sind über eine Kugelfläche 32 aneinander abgestützt. Im Tragteil ist vorzugsweise eine elektrische Heizpatrone 18 eingebaut (mit Speiseleitungen 19), von welcher der Stempel 20 über die Kugelfläche 32 beheizt wird.

Der Stempel 20 ist mit Distanzhaltemitteln versehen, die nach unten über die Stempelfläche 22 vorstehen und zur Auflage auf dem Substrat 6 (bei abgesenkter Einrichtung) bestimmt sind. Als Beispiel ist in Fig. 1 und 2 ein umlaufender, von der Stempelfläche abstehender Rand 24 dargestellt, der einen Hohlraum 28 unter dem Stempel begrenzt. Bezüglich möglicher Varianten der Distanzhaltemittel wird auf die Figuren 9 bis 11 und die Beschreibung weiter unten verwiesen.

Anhand der Fig. 2 wird nun die Wirkungsweise der Einrichtung in verschiedenen Phasen a bis e beschrieben. In der Ausgangsphase a des Arbeitszyklus ist die Einrichtung angehoben, und eine flüssige, tropfenförmig gewölbte Lotportion 8 befindet sich unter dem Stempel 20 auf dem Substrat. Infolge ungenauer Plazierung der Lotportion ist diese zur Vertikalachse 16 versetzt. Es sei ferner angenommen, dass der Stempel bzw. die Stempelfläche eine Schieflage relativ zum Substrat einnimmt (z.B. herrührend von einer vorangehenden Auflage auf einem schiefstehenden Substrat); infolge der reibschlüssigen Lagerung des Stempels behält dieser seine Lage zunächst bei.

Die Einrichtung wird nun gegen das Substrat hin abgesenkt. In Fig. 2b ist der Moment dargestellt, wo die eine Kante des (rechteckig angenommenen) Randes 24 gerade auf dem Substrat auftrifft. Das Lot 8' ist bereits teilweise abgeflacht und im Hohlraum 28 ausgebreitet. Die untere Endlage der Einrichtung ist in Fig. 2c dargestellt. Der Stempel liegt mit dem Rand 24 vollends auf dem Substrat auf. Indem ein geringer "Überhub" des Schaftes eingestellt wurde (der auch etwaige Dickenänderungen des Substrats usw. berücksichtigt), ist der Tragteil 30 bezüglich der Hülse 10 leicht angehoben, wodurch die sichere Auflage des Stempels gewährleistet ist. Der Stempel ist selbsttätig an der Substrat-Oberfläche ausgerichtet worden und die Stempelfläche 22 liegt zu dieser parallel. Anschliessend wird die Einrichtung wieder angehoben (Fig. 2d). Auf dem Substrat bleibt am gewünschten Ort (zentriert auf die Achse 16) die verformte Lotportion 8" zurück. Dank der Ausrichtung des Stempels und entsprechend der Höhe des Randes 24 weist die Lotverteilung eine über die Fläche praktisch gleichbleibende Dicke auf, wobei sie in der Mitte infolge der Oberflächenspannung des Lotes leicht überhöht ist. Im vorliegenden Fall (umlaufender Rand 24) ist die Fläche auch im Format bestimmt bzw. dem Format des aufzulötenden Chips angepasst. Es wird natürlich vorausgesetzt, dass die Lotportionen 8 so dosiert sind, dass ihr Volumen demjenigen des Hohlraumes 28 entspricht.

Ausserdem wird vorausgesetzt, dass der Stempel vom flüssigen Lot nicht benetzt wird. Als Werkstoff für den Stempel, mindestens dessen unteren Teil mit der Stempelfläche 22, eignen sich insbesondere Graphit oder Stahl.

Es kann nun ein neuer Arbeitszyklus beginnen. Solange sich bei den folgenden Zyklen die Lage der Substrat-Oberfläche nicht ändert, behält der Stempel seine Ausrichtung bezüglich der Achse 16 bei, d.h. es treten keine Lageanpassungen beim Absenken auf das Substrat ein. Einer etwa auftretenden Schieflage des Substrats (Fig. 2e) passt sich der Stempel jedoch sogleich und selbsttätig wieder an.

Im folgenden werden noch konkrete Ausführungsbeispiele für die schwenkbare und austauschbare Lagerung des Stempels beschrieben. Beim Beispiel nach Fig. 3 bis 6 ist hierfür eine generell mit 40 bezeichnete Kardanring-Anordnung vorgesehen. Der konzentrisch zur Kugelfläche 32 angeordnete Kardanring 41 ist mittels zweier Achsbolzen 42 an zwei Fortsätzen 13 gelagert, die von der Hülse 10 herabragen (Fig. 5). Auf dem zu den Bolzen 42 um 90° versetzten Ringdurchmesser sitzen zwei weitere Achsbolzen 44 im Ring 41 fest. Diese bilden die Auflage für zwei am Stempel 20a seitlich abstehende Schultern 23, welche auf der Unterseite je eine zentrierende Ausnehmung 27 aufweisen.

Mit der dargestellten Kardanlagerung ist der Stempel 20a allseitig schwenkbar. Es besteht dabei Reibschluss an der Kugelfläche 32, indem das Teil 30 von der Druckfeder 14 (Fig. 1) belastet ist, wodurch auch jegliches Lagerspiel aufgehoben ist. Durch die Kardanring-Anordnung ist der Stempel 20a auch gegen Drehung gegenüber der Hülse 10 gesichert. Der Stempel lässt sich leicht auswechseln, indem er angehoben und dann mit den Schultern 23 über die Bolzen 44 hinweg um 90° gedreht wird.

Das weitere Ausführungsbeispiel nach Fig. 7 und 8 zeigt eine Art Schnapp- oder "Druckknopf"-Befestigung des Stempels 20b. Unten am Tragteil 30b ist ein Kugelkopf 34 ausgebildet, von dem ein Teil 35 radial beweglich ist. Das Teil 35 ist an einem festsitzenden Stift 36 geführt und mit einer im Innern angebrachten Druckfeder belastet. Der Kugelkopf 34 ist ferner parallel zur Zeichnungsebene beidseitig abgeflacht (was nicht aus der Zeichnung ersichtlich ist). Der Stempel 20b weist eine oben offene, kugelige Höhlung 21 auf, die bei montiertem Stempel den Kugelkopf 34 übergreift. Wie ersichtlich, lässt sich der Stempel 20b leicht vom Kugelkopf abziehen bzw. auf diesen aufstecken, wobei er allseitig schwenkbar gehalten ist. Indem die vorstehenden Enden des Stiftes 36 in Schlitze 37 am Stempel eingreifen, ist der letztere gegen Drehung am Kugelkopf gesichert. Eine Drehsicherung des Tragteils 30b in Bezug auf die Hülse 10 ist durch einen im Teil 30b festsitzenden Stift 31 gegeben, dessen Enden in vertikalen Schlitzen 13 der Hülse gleitend geführt sind. Die unteren Enden der Schlitze 13 bestimmen auch die untere Endlage des (mit der Druckfeder 14 belasteten) Tragteils 30b.

Im weiteren werden noch verschiedene Ausführungsvarianten von Distanzhaltemitteln anhand der Figuren 9 bis 11 erläutert. Die Fig. 9 zeigt die bereits weiter oben erwähnte Ausgestaltung mit einem umlaufenden, von der Stempelfläche 22 abstehenden Rand 24. Von diesem werden, wie ausgeführt, das Volumen des "eingeschlossenen" Hohlraumes 28 wie auch Format und Höhe der entstehenden Lotverteilung bestimmt.

Eine Distanzhaltung der Stempelfläche 22 zum Substrat kann aber grundsätzlich gemäss Fig. 10 auch mit (mindestens) drei separaten Erhebungen 25 erreicht werden, die an geeigneten Stellen von der Stempelfläche abstehen; eine solche Ausführung ist anwendbar, wenn es auf ein genauer definiertes Format der Lotverteilung weniger ankommt.

Fig. 11 zeigt schliesslich eine Abwandlung der Distanzhaltemittel nach Fig. 9. Hier ist der Rand 24' an einzelnen Stellen 26 etwas weniger hoch, d.h. an diesen Stellen bleibt ein geringer Abstand zur Substrat-Oberfläche bestehen. Damit wird eine Art Entlüftung des Hohlraumes 28 beim Absenken des Stempels erreicht, die der raschen Ausbreitung des Lots bis an den Rand 24' förderlich sein kann. Für eine solche Entlüftung bestehen natürlich weitere Möglichkeiten, z.B. können der Ort und die Abmessungen der Stellen 26 variiert werden, oder es können im Rand 24' schmale Schlitze angebracht werden, die sich über die ganze Höhe des Randes erstrecken.

In der Fig. 11 ist noch mit strichpunktierten Linien die Möglichkeit angedeutet, in der Stempelfläche 22 Vertiefungen 29 oder generell Strukturen vorzusehen, mit denen die seitliche Ausbreitung des Lots auf dem Substrat beeinflusst werden kann, beispielsweise um die Strömung des Lots zu den Ecken hin zu fördern.

## Patentansprüche

1. Einrichtung zum Formen von flüssigen Lotportionen (8) als Vorbereitung beim Weichlöten von Halbleiterchips auf einem Substrat (6), mit einem in Bezug auf das Substrat heb- und senkbaren Schaft (10, 11) und einem mit diesem verbundenen Stempel (20), der eine untere, dem Substrat zugekehrte Stempelfläche (22) aufweist, **dadurch gekennzeichnet, dass** der Stempel (20) am Schaft (10, 11) vertikal federnd geführt und bezüglich dessen Bewegungsachse (16) allseitig schwenkbar sowie reibschlüssig gelagert ist, und dass am Stempel (20) Distanzhaltemittel (24, 25) vorhanden sind, die über die Stempelfläche (22) vorstehen und zum Aufsetzen auf dem Substrat (6) bestimmt sind.

2. Einrichtung nach Anspruch 1, **dadurch gekennzeichnet, dass** der Stempel (20) austauschbar an einem Tragteil (30) gehalten ist, das seinerseits am Schaft (10, 11) entgegen einer vorgespannten Feder (14) vertikal gleitend geführt ist.

3. Einrichtung nach Anspruch 2, **dadurch gekennzeichnet, dass** der Stempel (20) und das Tragteil (30) aneinander über eine Kugelfläche (32) abgestützt sind.

4. Einrichtung nach Anspruch 3, **dadurch gekennzeichnet, dass** der Stempel (20b) eine kugelförmige, einen Kugelkopf (34) am Tragteil (30b) übergreifende Höhlung (21) aufweist, wobei zwecks Schnappbefestigung des Stempels ein Teil (35) des Kugelkopfes federnd ausgebildet ist.

5. Einrichtung nach Anspruch 3, **dadurch gekennzeichnet, dass** der Stempel (20a) mittels einer Kardanring-Anordnung (40) am Tragteil (30) gehalten ist.

6. Einrichtung nach Anspruch 3, **gekennzeichnet durch** im Tragteil (30) eingebaute Heizmittel (18) zur Beheizung des Stempels (20) über die Kugelfläche (32).

7. Einrichtung nach Anspruch 1, **dadurch gekennzeichnet, dass** die Distanzhaltemittel durch einen von der Stempelfläche (22) abstehenden, einen Hohlraum (28) für die Lotportion begrenzenden Rand (24) gebildet sind.

8. Einrichtung nach Anspruch 7, **dadurch gekennzeichnet, dass** der Rand (24') an bestimmten Stellen (26) eine geringere Höhe aufweist oder mit Schlitzen versehen ist.

9. Einrichtung nach Anspruch 1, **dadurch gekennzeichnet, dass** die Distanzhaltemittel durch mindestens drei vom Randbereich der Stempelfläche (22) ausgehende Erhebungen (25) gebildet sind.

10. Einrichtung nach Anspruch 1, **dadurch gekennzeichnet, dass** die Stempelfläche (22) mit Vertiefungen (29) oder anderen Strukturen versehen ist, um die Ausbreitung des Lots auf dem Substrat (6) zu beeinflussen.

## Claims

1. Apparatus for forming liquid solder portions (8) in preparation of soft soldering semiconductor chips to a substrate (6), with a shaft (10,11) which can be lifted and lowered with respect to the substrate, and a punch (20) connected to the shaft and provided with a lower surface (22) directed at the substrate, **characterized in that** the punch (20) is spring mounted and guided vertically along the shaft (10, 11), slewable in all directions with respect to the axis of motion (16) of the shaft, as well as frictionally engaged, and **in that** distance keeping means (24, 25) are provided at the punch (20), protruding beyond the lower surface (22) of the punch and intended to touch down on the substrate (6).

2. Apparatus according to claim 1, **characterized in that** the punch (20) is replaceably mounted on a supporting part (30), which in turn is slidingly guided vertically along the shaft against a prestressed spring (14).

3. Apparatus according to claim 2, **characterized in that** the punch (20) and the supporting part (30) are mutually engaged by means of a spherical surface (32).

4. Apparatus according to claim 3, **characterized in that** the punch (20) is provided with a spherical cavity (21) enclosing a spherical head (34) on the supporting part (30b), with a part (35) of the spherical head being resilient for a snap-on fastening of the punch.

5. Apparatus according to claim 3, **characterized in that** the punch (20a) is attached to the supporting part (30) by means of a gimbals arrangement (40).

6. Apparatus according to claim 3, **characterized by** heating means (18) provided at the supporting part (30) for heating of the punch (20) via the spherical surface (32).

7. Apparatus according to claim 1, **characterized in that** the distance keeping means are formed by a rim (24) extending from the punch surface (22) and forming a hollow space (28) for the solder portion.

8. Apparatus according to claim 7, **characterized in that** the rim (24') has a lower height in certain places (26) or is provided with slots.

9. Apparatus according to claim 1, **characterized in that** the distance keeping means are formed by at least three protrusions (25) extending from the boundary of the punch surface (22).

10. Apparatus according to claim 1, **characterized in that** the punch surface (22) is provided with cavities (29) or some other structures for influencing the dispersion of solder on the substrate (6).

## Revendications

1. Dispositif pour le formage de parts de brasure (8) liquides en préalable au brasage doux de puces de semi-conducteurs sur un substrat (6), avec une tige (10, 11) pouvant être abaissée vers le substrat et relevée et d'un tampon (20) relié à celle-ci, qui présente une face de tampon inférieure (22) orientée vers le substrat, **caractérisé en ce que** le tampon (20) est guidé sur la tige (10, 11) de façon élastique dans le sens vertical et supporté de toutes parts de façon pivotante et par adhérence par rapport à l'axe de déplacement (16) de celle-ci, et **en ce qu'**il est prévu sur le tampon (20) des moyens d'écartement (24, 25) qui font saillie au-delà de la face du tampon (22) et sont destinés à s'appuyer sur le substrat (6).

2. Dispositif selon la revendication 1, **caractérisé en ce que** le tampon (20) est retenu de façon interchangeable sur une partie portante (30) qui est pour sa part guidée de façon coulissante verticalement sur la tige (10, 11) contre la force d'un ressort (14) précontraint.

3. Dispositif selon la revendication 2, **caractérisé en ce que** le tampon (20) et la partie portante (30) s'appuient l'un sur l'autre par l'intermédiaire d'une surface sphérique (32).

4. Dispositif selon la revendication 3, **caractérisé en ce que** le tampon (20b) présente in évidement (21) sphérique entourant une tête sphérique (34) sur la partie portante (30b), une partie (35) de la tête sphérique étant élastique en vue d'une fixation par emboîtement du tampon.

5. Dispositif selon la revendication 3, **caractérisé en ce que** le tampon (20a) est retenu sur la partie portante (30) au moyen d'un dispositif à bague à cardan (40).

6. Dispositif selon la revendication 3, **caractérisé en ce que** des moyens chauffants (18) sont intégrés dans la partie portante (30) en vue de chauffer le tampon (20) par l'intermédiaire de la surface sphérique (32).

7. Dispositif selon la revendication 1, **caractérisé en ce que** les moyens d'écartement sont formés par un bord (24) dépassant de la face de tampon (22) et délimitant une cavité (28) pour la part de brasure.

8. Dispositif selon la revendication 7, **caractérisé en ce que** le bord (24') présente en certains endroits (26) une hauteur réduite ou est muni de fentes.

9. Dispositif selon la revendication 1, **caractérisé en ce que** les moyens d'écartements sont formés par au moins trois saillies (25) dépassant du bord de la face de tampon (22).

10. Dispositif selon la revendication 1, **caractérisé en ce que** la face de tampon (22) est pourvue de creux (29) ou d'autres structures afin d'influencer la répartition de la brasure sur le substrat (6).
